# EUROPEAN PATENT APPLICATION

(11) **EP 4 554 072 A1**
(43) Date of publication of application: **14.05.2025**
(21) Application number: 23306949.1
(22) Date of filing: 10.11.2023
(51) Int. Cl.: H02M 1/08, H03K 17/18, H03K 17/691, H03K 17/78

(54) **OVERLAPPING REDUCTION FOR CURRENT SOURCE CONVERTERS USING GATE CURRENT MIRRORS**

(71) Applicant: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: Lefevre, Guillaume, 35708 RENNES CEDEX 7 (FR); Le Leslé, Johan, 35708 RENNES CEDEX 7 (FR)
(74) Representative: Plasseraud IP

(57) **Abstract**

Control circuit for a current source converter having a current generator comprising an inductance (2) and having two or more half bridges each half bridge having an upper leg provided with an upper switching device (11, 13) and a lower leg provided with a lower switching device (12, 14), said upper legs switching devices and said lower legs switching devices being controlled by a controller (40) to provide an overlap between an upper leg turning off switching device (11, 13) and an upper leg turning on switching device (13, 11) and to provide an overlap between a lower leg turning on switching device (12, 14) and a lower leg turning off switching device (14, 12) through gate pull up and gate pull down pulse signals to gate drivers buffers (6) of said switching devices, said gate driver circuit comprising:
- for each upper leg switching device and each lower leg switching device (11, 12, 13, 14) a gate current mirroring circuit (51) on a source branch of the gate driver buffer (6) of said switching device (11, 12, 13, 14) to provide a gate pull down signal (Gpₓ, Gp_{y}) upon turning OFF of said switching device, said gate pull down signal (Gpₓ, Gp_{y}) being connected to a control line (Cl) of a gate buffer (6) of a respective further upper leg switching device or further lower leg switching device (11, 12, 13, 14),
- for each upper leg switching device and each lower leg switching device (11, 12, 13, 14) a positive gate command connection path (G+) from a positive gate command output of a pre-driver (7) to provide a reset signal (RSTx, RSTy) for a respective further upper leg switching device and lower leg switching device (11, 12, 13, 14) gate pull down signal.

## Description

### Technical Field

This disclosure pertains to the field of current source converters comprising at least two switching half-bridges having each an upper switching device and a lower switching device and where a ON state overlapping between upper switching devices or between lower switching devices of two half-bridges having opposite switching transition periods is needed to avoid a current interruption which would cause an overvoltage in the converter.

### Background Art

Current source converters are used for different applications, such as HVDC, motor drive or power factor corrector. The main limitation of such converter mainly was the use of bulky input inductances and power modules designed for conventional switching cells. However, the growing emergence of wide bandgap devices, e.g Silicone Carbide and/or Gallium Nitride, with lower conductive and switching losses opened up new perspectives for current fed converter design by reducing size and improving efficiency.

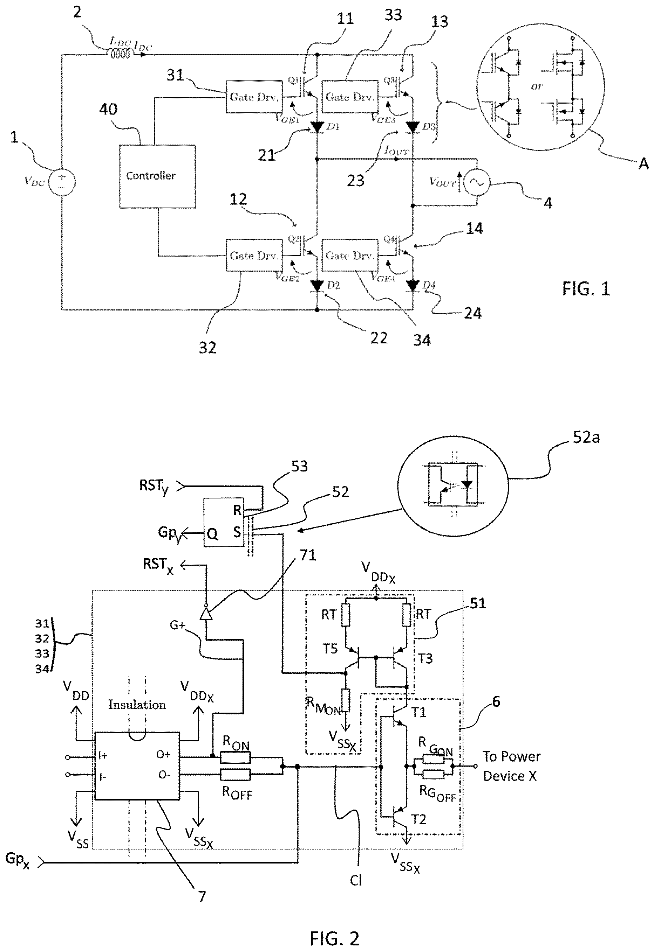

Current source power converters, abbreviated as CSC, comprise at least two half-bridges where the switches of the upper legs of two half-bridges and the switches of the lower legs of two half-bridges are controlled in a complementary way with conducting to blocking and blocking to conducting transitions. Between these transitions, overlapping where both upper switches, or both lower switches are ON is used. The main reason of the overlapping is due to the nature of the current source which is an inductive source which should not be interrupted. Current interruption can be due to multiple factors, including wrong control signal of one of the two switches, a faulty device failed in open circuit or a failed gate driver. In such cases, no current path for the DC current can lead to tremendous damage since current interruption in current source or current fed converter induces a fast increase in the voltage across the semiconductor device, higher than the breakdown voltage of such semiconductor and which may cause destruction of the power converter. In such a case, the power switch devices which incur the overvoltage may enter in an avalanche mode and dissipate the energy stored in the inductance. Since these devices cannot withstand such conditions, high voltage and high current, during too much time these may be destroyed. This situation already creates the necessity of an overlap between upper switching devices or between lower switching devices having opposite switching transition periods of half-bridges of current source converters e.g. such as an inverter type such as shown in figure 1. Nonetheless, a reduction of the overlapping time is beneficial for the overall converter operation. First, a too high overlapping time would lead to a high Total Harmonic Distortion (THD) of the output current. Some software solutions can be implemented in the control loop to mitigate such side effects. In addition, the reduction of the overlapping time could reduce the losses in case of a CSC having current bidirectionality feature, see the device assembly presented in the circle A of Figure 1. The control of the two devices placed in series depends on the overlapping time, the longer the overlapping time, the longer is the conduction of one of the body diodes, thus the conduction losses increase because of the high forward voltage.

### Summary

This disclosure improves the situation in providing a switching system where the overlapping between conducting to non-conducting and non-conducting to conducting power semiconductor switches in a current fed converter is reduced without the need of reducing the overlapping calculated by a controller of the converter.

More precisely the present disclosure proposes a control circuit for a current source converter having a current generator comprising an inductance and having two or more half bridges each half bridge having an upper leg provided with an upper switching device and a lower leg provided with a lower switching device, said upper legs switching devices and said lower legs switching devices being controlled by a controller to provide an overlap between an upper leg turning off switching device and an upper leg turning on switching device and to provide an overlap between a lower leg turning on switching device and a lower leg turning off switching device through gate pull up and gate pull down pulse signals to gate drivers buffers of said switching devices, characterized in that said gate driver circuit comprises:
- for each upper leg switching device and each lower leg switching device a gate current mirroring circuit on a source branch of the gate driver buffer of said switching device to provide a gate pull down signal upon turning OFF of said switching device, said gate pull down signal being connected to a control line of a gate buffer of a respective further upper leg switching device or further lower leg switching device,
- for each upper leg switching device and each lower leg switching device a positive gate command connection path from a positive gate command output of a pre-driver to provide a reset signal or a respective further upper leg switching device and lower leg switching device gate pull down signal.

Said gate pull-down signal may be output from a MOS transistor which gate receives a pulse issued from said gate current mirroring circuit, said MOS transistor having or not a filtering capacitor between the gate and a source of said MOS transistor.

Said gate pull-down signal may be an output of a SR gate having as input a current image of the gate current and issued from said gate current mirroring circuit.

The control circuit may comprise an inverter gate to provide said reset signal from said positive gate command connection path.

Said reset signal may polarize a gate of a MOS transistor to discharge the gate of said MOS transistor or to discharge the gate of said MOS transistor and said filtering capacitor.

When said gate pull-down signal is an output of a SR gate having as input a current image of the gate current and issued from said gate current mirroring circuit, said reset signal may be connected to a reset input of said SR gate.

The pre-driver may provide a first galvanic isolation between a controller circuit and the gate buffer.

The control circuit may comprise a second galvanic isolation between the gate current mirror circuit and the gate pull down signal circuit.

Said second galvanic isolation may be provided with a transformer in the collector branch of a current mirror transistor.

Said second galvanic isolation may also be provided with a photocoupler in the collector branch of a current mirror transistor or another insulating component.

The present disclosure also concerns a converter or an inverter comprising a current source, a controller, at least two half-bridges provided with upper legs switching devices and lower legs switching devices, each of said switching devices being controlled by said controller through gate drivers, wherein said gate drivers comprise control circuits according to any one of the preceding claims.

The present disclosure concerns further a method for switching power switch devices of legs of half-bridges of a current source converter with reduced overlapping time, where ON, OFF states of said power switch devices of said legs are driven by a controller through gate drivers provided with gate buffers, characterized in that during a switching transition between a first upper leg power switch device and a second upper leg power switch device or a switching transition between a first lower leg power switch device and a second lower leg power switch device, said switching transitions being initiated by a controller through said gate drivers of the power switch devices, the method comprises using a mirrored gate current, or a voltage proportional to such mirrored gate current, from one of said power switch devices having an OFF state to ON state transition in order to commutate the other of said switches devices from a ON state to an OFF state earlier than a gate pulse issued from said controller to a gate driver of said second switch device provided for commutating said other of said switches devices from said ON state to said OFF state.

The method may comprise providing a gate pull down pulse signal issued from said mirrored gate current, or a voltage proportional to such mirrored gate current, said gate pull down pulse signal being used for commutating the other of said switches devices from said ON state to said OFF state.

Said mirrored gate current may be a mirrored source current of gate buffers driving said power switch devices.

The method may comprise latching said mirrored gate current or voltage proportional to said mirrored gate current to provide said gate pull down pulse signal and resetting said gate pull down pulse signal at an end of said transition.

### Brief Description of Drawings

Other features, details and advantages will be shown in the following detailed description and on the figures, on which:
Figure 1 is a schematic view of a single phase current source inverter;
Figure 2 is a schematic view of an example of control circuit according to an embodiment of the present disclosure;
Figures 3 shows an example of control circuit of two legs of a converter of the present disclosure;
Figure 4 shows a schematic view of a traditional three phases current source inverter;

### Description of Embodiments

Figure 1 is a schematic view of a DC/AC current source converter also called inverter. Such converter comprises a DC source 1 an inductance 2 and two half bridges. A first half-bridge comprises first upper leg power switch device 11 with IGBT Q1 and a diode 21 and first lower leg power switch device 12 with IGBT Q2 and diode 22. A second half-bridge comprises second upper leg power switch device 13 with IGBT Q3 and a diode 23 and second lower leg power switch device 14 with IGBT Q4 and diode 24. The IGBT+ diode design shown may be replaced with serial opposite polarity IGBTs with reverse freewheeling diodes or serial reverse polarity MOSFET having inherent body diode or with additional freewheeling diodes such as in circle A.

The half-bridges of the current source converter are connected to an alternating voltage and current load 4.

The switches are controlled through gate drivers, a first gate driver 31 for the first half-bridge first upper leg switch device 11, a second gate driver 32 for the first half-bridge first lower switch device 12, a third gate driver 33 for the second upper leg switch device 13 of the second half bridge and gate driver 34 for the second lower leg switch device 14 of the second half-bridge. In such a converter, opposite switching between upper legs power switch devices and opposite switching between lower legs power switch devices is needed to create the alternating current in the alternative load 4. Due to the inductive current source caused by the inductance 2, it is mandatory that an overlapping occurs when a power switch device turns OFF while another turns ON on the upper leg side or on the lower leg side.

Starting from the basic schematics of figure 1, the present disclosure concerns a driver circuit that aims to reduce the overlap in order to reduce losses in the converter and heat dissipation in the power switches.

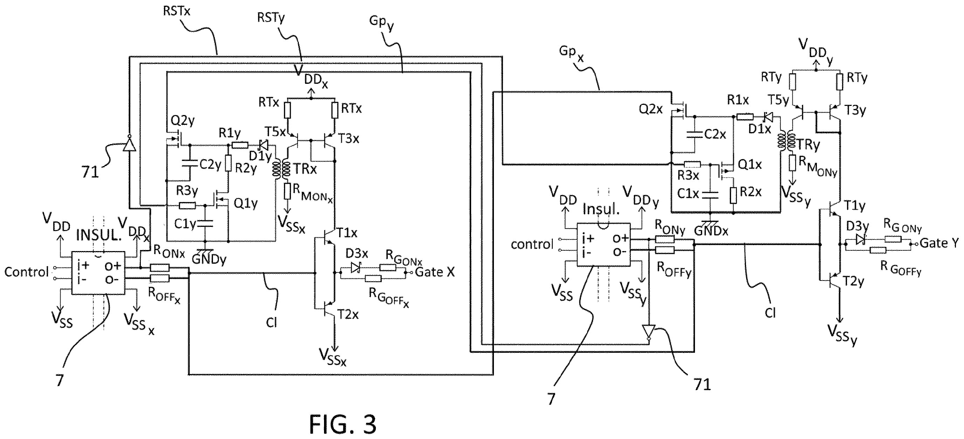

To do this the driver circuit is designed as in figure 2 or in figure 3 to add an early turn OFF function of a first switch upon turning ON of a second switch in the same leg level (upper leg level or lower leg level) in the driver circuit.

In figure 2 the driver circuit 31 comprises a pre-driver 7 which provides a first galvanic isolation between the controller power supply V_{DD}, Vss and the power switch X gate buffer circuit 6 having a V_{DDx} and V_{SSx} power supply.

In the presented circuit, a gate current mirror circuit 51 having transistors T3 and T4 is positioned in the source branch of the push pull buffer 6 having transistors T1 and T2.

The image of the source current of the buffer 6 is taken at the junction of the resistor R_{MON} and the collector of transistor T5.

This source current corresponds to the gate current of the power switch device X during its OFF to ON transition.

In figure 2, a second galvanic isolation 52 made with an optocoupler 52a transfers the signal extracted from the current mirror to a SR gate which output provides a signal Gp_{y} used as discussed hereunder to turn off a power switch device Y, as seen in figure 3, prior to reception of the controller switch closing signal I-.

On the other side, the same driver circuit is realized for the power switch Y and the power device Y provides in turn a Gpₓ signal which will turn off the power switch device X OFF prior to reception of the controller signal during an OFF to ON transition of the power switch device Y.

This can be seen in figure 3 where the complete driver circuit for two upper or lower legs of a converter is shown.

In figure 3 the SR gates are replaced by MOS transistors Q1x, Q2x in the driver circuit of the gate Y of power switch Y and Q1y, Q2y in the driver circuit of the gate X of power switch X.

These MOS transistors receive an image of the gate driver current through transformers TRx and Try which provide the second galvanic isolation in replacement of the optocouplers 52a.

Here the image from the gate driver current of switch Y goes through a Schottky diode D1x and on the gate of Q2x to provide the signal GPx that will pull down the gate buffer of switch X, the image from the gate driver current of switch X goes through a Schottky diode D1y and on the gate of Q2y to provide the signal GPy that will pull down the gate buffer of switch Y.

On the other side, the O+ signal to turn on switch Y provides the signal RSTy through an inverter 71, such signal being provided to pull down the gate of MOS transistor Q2y through MOS transistor Q1y and the O+ signal to turn on switch X provides the signal RSTx through a further inverter 71, such signal being provided to pull down the gate of MOS transistor Q2x through MOS transistor Q1x.

This second realization mode only based on transistors and passive components is simpler to embed in a power module than logic components as in figure 2 and provides the same function.

The disclosed circuits provide a simple way to reduce the ON overlap between switches without creating open circuit conditions since it is based on detection of the OFF to ON transition of a first switch to anticipate the ON to OFF transition of the second switch which is controlled in a complementary way from the first switch.

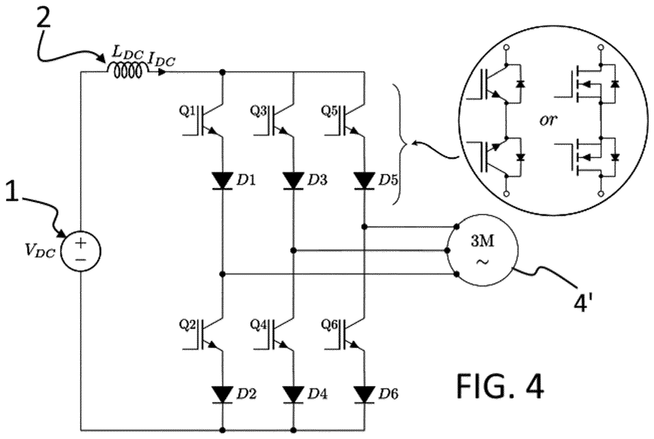

The present invention is not limited to the described circuits and in example, the control circuit described may be adapted to a three-phase output current source converter as per figure 4 with the use of adapted logic circuits and isolation to combine the gate command signals and gate pull down detection signals of three half-bridges. Also, the present disclosure may be applied to DC/AC converters but also to AC/DC converters, the source and load being reversed.

In addition, the present invention may be combined with a circuit designed to protect the current source converter, such circuit using a sink current mirror circuit similar to the source current mirror depicted.

## Claims

1. - Control circuit for a current source converter having a current generator comprising an inductance (2) and having two or more half bridges each half bridge having an upper leg provided with an upper switching device (11, 13) and a lower leg provided with a lower switching device (12, 14), said upper legs switching devices and said lower legs switching devices being controlled by a controller (40) to provide an overlap between an upper leg turning off switching device (11, 13) and an upper leg turning on switching device (13, 11) and to provide an overlap between a lower leg turning on switching device (12, 14) and a lower leg turning off switching device (14, 12) through gate pull up and gate pull down pulse signals to gate drivers buffers (6) of said switching devices, **characterized in that** said gate driver circuit comprises:
- for each upper leg switching device and each lower leg switching device (11, 12, 13, 14) a gate current mirroring circuit (51) on a source branch of the gate driver buffer (6) of said switching device (11, 12, 13, 14) to provide a gate pull down signal (Gpₓ, Gp_{y}) upon turning OFF of said switching device, said gate pull down signal (Gpₓ, Gp_{y}) being connected to a control line (CI) of a gate buffer (6) of a respective further upper leg switching device or further lower leg switching device (11, 12, 13, 14),
- for each upper leg switching device and each lower leg switching device (11, 12, 13, 14) a positive gate command connection path (G+) from a positive gate command output of a pre-driver (7) to provide a reset signal (RSTx, RSTy) for a respective further upper leg switching device and lower leg switching device (11, 12, 13, 14) gate pull down signal.

2. - Control circuit according to claim 1 wherein said gate pull-down signal is output from a MOS transistor (Q2x, Q2y) which gate receives a pulse issued from said gate current mirroring circuit, said MOS transistor having or not a filtering capacitor (C2x, C2y) between the gate and a source of said MOS transistor.

3. - Control circuit according to claim 1 wherein said gate pull-down signal is an output of a SR gate having as input a current image of the gate current and issued from said gate current mirroring circuit.

4. - Control circuit according to claim 1 comprising an inverter gate (71) to provide said reset signal (RSTx, RSTy) from said positive gate command connection path (G+).

5. - Control circuit according to claims 2 and 4 wherein said reset signal (RSTx, RSTy) polarizes a gate of a MOS transistor (Q1x, Q1y) to discharge the gate of said MOS transistor (Q2x, Q2y) or to discharge the gate of said MOS transistor (Q2x, Q2y) and said filtering capacitor (C2x, C2y).

6. - Control circuit according to claims 3 and 4 wherein said reset signal (RSTx, RSTy) is connected to a reset input of said SR gate (53).

7. - Control circuit according to any one of the preceding claims wherein the pre-driver (7) provides a first galvanic isolation between a controller circuit and the gate buffer.

8. - Control circuit according to any one of the preceding claims comprising a second galvanic isolation (52) between the gate current mirror circuit (51) and the gate pull down signal circuit.

9. - Control circuit according to claim 8 wherein said second galvanic isolation is provided with a transformer (TRx, Try) in the collector branch of a current mirror transistor (T5x, T5y).

10. - Control circuit according to claim 8 wherein said second galvanic isolation (52) is provided with a photocoupler (52a) in the collector branch of a current mirror transistor (T5x, T5y).

11. - Converter such as an inverter comprising a current source (1, 2), a controller (40), at least two half-bridges provided with upper legs switching devices (11, 13) and lower legs switching devices, each of said switching devices being controlled by said controller (40) through gate drivers (31, 32, 33, 34), wherein said gate drivers comprise control circuits according to any one of the preceding claims.

12. - Method for switching power switch devices of legs of half-bridges of a current source converter (1, 2) with reduced overlapping time, where ON, OFF states of said power switch devices of said legs are driven by a controller (40) through gate drivers (31, 32, 33, 34) provided with gate buffers (6), **characterized in that** during a switching transition between a first upper leg power switch device (11, 13) and a second upper leg power switch device (13, 11) or a switching transition between a first lower leg power switch device (12, 14) and a second lower leg power switch device (14, 12), said switching transitions being initiated by said controller (40) through said gate drivers of the power switch devices, the method comprises using a mirrored gate current, or a voltage proportional to such mirrored gate current, from one of said power switch devices having an OFF state to ON state transition in order to commutate the other of said switches devices from a ON state to an OFF state earlier than a gate pulse issued from said controller (40) to a gate driver of said second switch device provided for commutating said other of said switches devices from said ON state to said OFF state.

13. - Method according to claim 12 comprising providing a gate pull down pulse signal (Gpₓ, Gp_{y}) issued from said mirrored gate current, or a voltage proportional to such mirrored gate current, said gate pull down pulse signal (Gpₓ, Gp_{y}) being used for commutating the other of said switches devices from said ON state to said OFF state.

14. - Method according to claim 12 or 13 wherein said mirrored gate current is a mirrored source current of gate buffers driving said power switch devices (11, 12, 13, 14).

15. - Method according to claim 13 comprising latching said mirrored gate current or voltage proportional to said mirrored gate current to provide said gate pull down pulse signal and resetting said gate pull down pulse signal at an end of said transition.
